Europäisches Patentamt

European Patent Office

Office européen des brevets

(11) Publication number: **0 285 820**

**A2**

# EUROPEAN PATENT APPLICATION

(21) Application number: 88103369.0

(51) Int. Cl.⁴: **H01L 23/48** , **H01L 23/54**

(22) Date of filing: 04.03.88

(30) Priority: 06.04.87 US 34198

(43) Date of publication of application:
**12.10.88 Bulletin 88/41**

(84) Designated Contracting States:
**DE FR GB**

(71) Applicant: **International Business Machines
Corporation
Old Orchard Road
Armonk, N.Y. 10504(US)**

(72) Inventor: **Lamey, Patrick J.
10168 Statesboro Court
Manassas Virginia 22110(US)**
Inventor: **Peterman, Steven L.
7779 Beadfield Court
Manassas Virginia 22110(US)**

(74) Representative: **Mönig, Anton, Dipl.-Ing.
IBM Deutschland GmbH Schönaicher
Strasse 220
D-7030 Böblingen(DE)**

(54) **Method and structure for identifying non-functional chip connect pads.**

(57) To facilitate inspection, the pad metal level of a semiconductor chip (10) includes terminal pads having two different shapes. The terminal pads (18) that are to be functional are patterned in a first shape and the non-functional terminal pads (20) are patterned in an easily distinguishable second shape. Since the final passivation layer is transparent, the two shapes can be distinguished during inspection following the fabrication of solder balls, and rework of defective solder balls on non-functional pads can be avoided.

FIG. 1.

EP 0 285 820 A2

## Method and Structure for Identifying Non-Functional Chip Connect Pads

This invention relates to the field of semiconductor chip connections. In particular, a structure for and method of making a distinctive non-functional chip terminal pad is disclosed and claimed.

In very large scale integrated (VLSI) circuits, the number of inputs and outputs to a semiconductor chip can be on the order of several hundreds to a thousand. To accommodate this large number of input/output (I/O) connections in a small space, a number of chip connection processes have been used successfully.

In one method, the last level of metal interconnect wiring of a chip, known as pad metal, is patterned to include an array of terminal pads where chip I/O are desired. This last level of metal is then coated with a passivation/insulation layer, such as polyimide. Terminal vias are then patterned and etched through the passivation/insulation layer and subsequently filled with an additional layer of metal which forms a surface metallurgy or ball limiting metallurgy (BLM).

In those applications where solder balls are used for chip I/O connections, it is common to form an array of solder balls evenly distributed on the surface of the chip to facilitate mounting and distribution of stresses evenly across the chip. However, not all of the solder balls are necessarily needed for I/O purposes on a given chip. Therefore, a number of solder balls are attached to non-functional terminal pads.

During solder balls fabrication, occasionally some will be malformed, missing, etc. often resulting in costly rework. When the defective solder balls are formed on non-functional terminal pads, there is no need to go through the rework process. However, the identification of functional/non-functional solder balls has required the use of special microscopes or masking microscopes due to the small dimensions involved. This is a very costly, labor-intensive operation. The alternative of not depositing solder balls on non-functional pads is also not practical because this alternative would require separate deposition masks for each chip product. Furthermore, the redistribution of stresses on the functional solder balls would lead to premature failure of the solder ball connections.

The invention as claimed solves the problem of providing a terminal pad structure that facilitates the identification of non-functional terminal pads without requiring, for instance, the use of specialized microscopes. Further, the invention provides a process for making terminal pads that can be identified without the use of specialized microscopes.

In summary of the invention, a semiconductor chip is fabricated using standard practices up to the pad level, or last level of metal. At the pad metal level, the terminal pads that are to be functional are patterned in a first shape and the non-functional terminal pads are patterned in an easily distinguishable second shape. Since the final passivation layer is transparent, the two shapes can be distinguished during inspection following the fabrication of solder balls, and rework of defective solder balls on non-functional pads can be avoided.

The invention will be more fully understood with reference to the description of the preferred embodiment and with reference to the drawings wherein:

Fig. 1 is an exploded top view of a section of the pad metal level of a semiconductor chip.

Fig. 2 is a diagrammatic view of a functional terminal pad.

Fig. 3 is a diagrammatic view of a non-functional terminal pad.

Fig. 4 is a cross-sectional view of a semiconductor chip showing the pad level metal and ball limiting metallurgy.

Fig. 5 is a diagrammatic view of a functional terminal pad after terminal via etch.

Fig. 6 is a diagrammatic view of a non-functional terminal pad after terminal via etch.

Fig. 7 is a cross-sectional view of a semiconductor chip after a solder ball formation.

Fig. 8 is a diagrammatic view of a functional terminal pad following solder ball fabrication.

Fig. 9 is a diagrammatic view of a non-functional pad terminal pad after solder ball deposition.

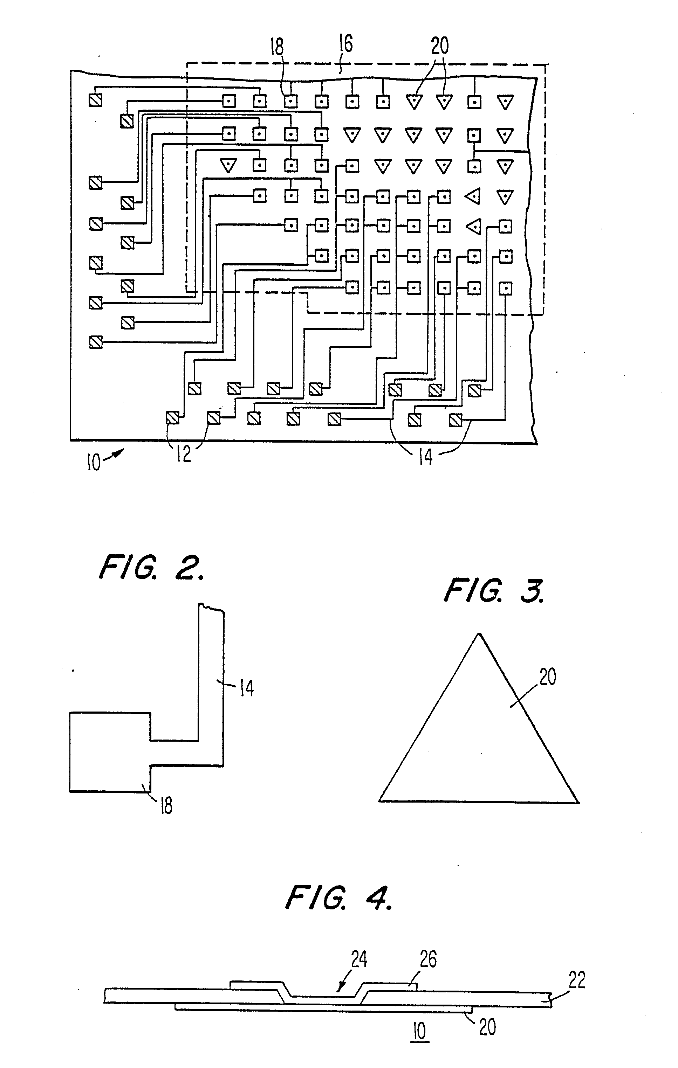

Fig. 1 illustrates a section of the terminal pad metal layer which is deposited on a semiconductor chip 10 after the device fabrication and interconnection processes are completed. The type of and processes for making the semiconductor devices are not critical to this invention, nor are the methods of interconnecting the devices. For example, the integrated circuit can have 1, 2, 3 or any number of metal interconnect layers under the pad level metal.

The terminal pad metal level includes via pads 12 along the periphery of the chip 10. Via pads 12 connect through one or more underlying layers (not shown) down to underlying devices and interconnection metallurgy. Metal lines 14 carry the electrical signals from the via pads 12 to an array of terminal pads shown within the dotted area 16.

Within the area 16 are functional terminal pads 18 that will carry electrical signals to and from the chip 10. These functional pads 18 have a first shape which is square in the preferred embodiment. Also, within the pad array area 16 are non-functional terminal pads 20 which have a second shape which is easily distinguishable from the first square shape. In the preferred embodiment, this shape is triangular.

Fig. 2 shows a blown-up functional terminal pad 18 with metal line 14 connecting it to a via pad (not shown). Fig. 3 shows a non-functional triangular terminal pad 20. Since pad 20 is non-functional, i.e., there are no inputs or outputs to it, there is no corresponding metal line attached.

The process for depositing the pad metal level is the same as currently practiced in the art. The only difference is that the mask used to define the pad level metal has both triangular and square terminal pad shapes, rather than just one shape as currently practiced. Also, the choice of materials is the same as practiced in the art is are of no significance to This invention.

After the pad metal level is deposited, the entire semiconductor chip is coated with a passivation/insulation layer such as polyimide. Other passivation/insulation layers can be used, but it is preferable to use a material that is easily applied and is transparent.

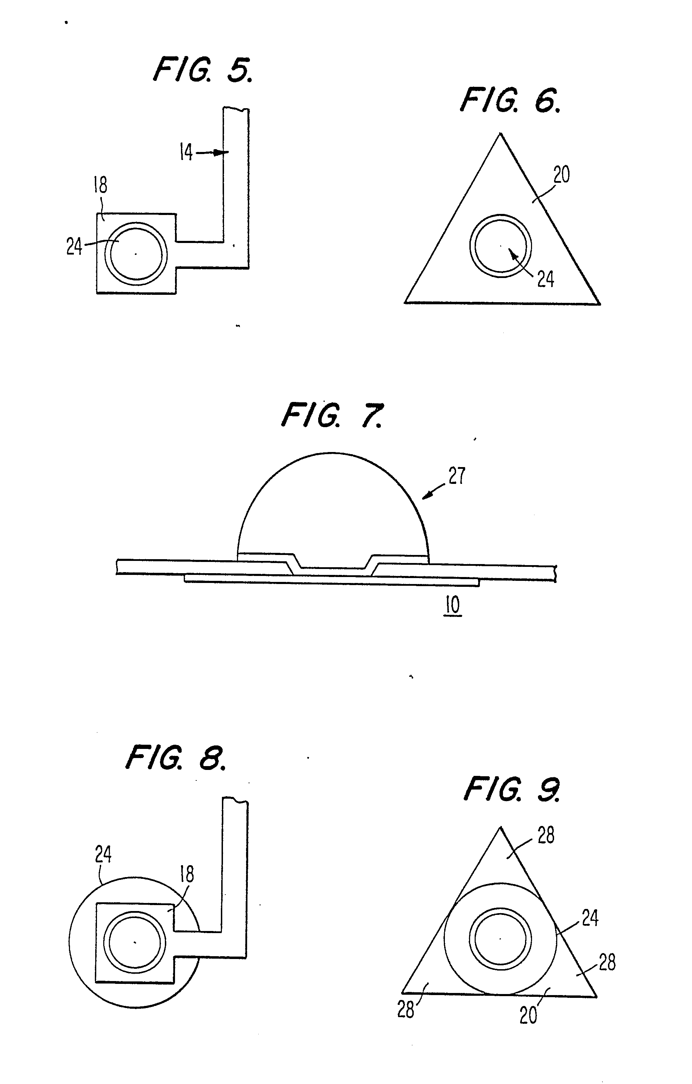

Referring to Fig. 4, the semiconductor chip 10 includes the terminal pad 20 which, in this case is a triangular, non-functional pad 20. Applied over the pad metal layer is the polyimide passivation/insulation layer 22. In order to make contact through the polyimide layer 22, it is necessary to etch terminal via 24 through the polyimide layer 22. The steps for this process are beyond the scope of this invention. After etching the via 24, the functional terminal pads 18 and non-functional pads 20 would appear as in Figs. 5 and 6, respectively.

Referring back to Fig. 4, after the etching steps, the ball limiting metallurgy 26 is deposited through appropriate masks. The ball limiting metallurgy, which can comprise chrome, copper, titanium, gold, nickel, tungsten or any other metals conventionally used for interconnection, makes contact through the via 24 down to the underlying terminal pads 20 or 18. Figs. 8 and 9 illustrate the relative dimensions of the ball limiting metallurgy 24 with respect to the functional terminal pad 18 and non-functional pad 20. The ball limiting metallurgy 24 will define the dimensions of the solder balls which are subsequently deposited. The solder balls are deposited in a manner wellknown in the art, one method of which is disclosed in U.S. Patent 4,290,079, which is commonly assigned to the assignee of this invention and is hereby incorporated by reference. The cross-section of the semiconductor chip 10 appears as is shown in Fig. 7.

It is readily observed (Fig.    that when a solder ball 27 is fabricated on top of a functional terminal pad 18, the terminal pad 18 will no longer be visible from inspection from above due to its smaller dimension than the solder ball. Conversely, because the non-functional pad 20 in Fig. 9 is chosen to be of a different shape with dimensions larger than the solder ball, corners 28 of the triangular terminal pad 20 will not be covered by the ball limiting metallurgy 24 or solder ball and can be readily identified when viewed through a conventional microscope. In this manner, if a solder ball is missing or defective, and an inspector observes that this solder ball lies over a non-functional pad, this defect can be ignored and costly rework can be avoided.

While the invention has been particularly shown and described with reference to a preferred embodiment thereof, it will be understood by those skilled in the art that various changes in detail may be made therein without departing from the spirit, scope and teaching of the invention. For example, the shapes and dimensions of the functional and non-functional terminal pads could be selected differently. Accordingly, the structure and process herein disclosed is to be considered merely as illustrative, and the invention is to be limited only as specified in the claims.

**Claims**

1. In an integrated circuit having semiconductor devices and interconnection metallurgy, an improved terminal pad metal level comprising:

a pattern of terminal pads including at least one functional terminal pad (18) having a first shape and at least one non-functional terminal pad (20) having a second shape, whereby non-functional pads can be distinguished by the shape of said pads.

2. The structure as claimed in claim 1 wherein said first shape is a quadrilateral.

3. The structure as claimed in claims 1 or 2 wherein said second shape is triangular.

4. A semiconductor chip (10) device comprising:

a plurality of semiconductor devices;

at least one layer of interconnection metallurgy supplying input/output signals to said devices;

a pad metal level having a pattern of terminal pads, said pattern of terminal pads including at least one functional pad (18) having a first shape and at least one non-functional pad (20) having a second shape;

an insulating layer overlying said pad metal level;

terminal vias (12) connecting through said insulating layer;

a ball limiting layer of metal making contact through said terminal vias; and

a plurality of solder balls formed on said ball limiting layer.

5. The structure as claimed in claim 4 wherein said insulating layer is transparent for inspection from above.

6. The structure of one of the preceding claims wherein the terminal pads are of different shapes with dimensions larger relative to the respective dimension of a later applied solder ball and, respectively, smaller than said solder ball as to be no longer visible from inspection from above (Figs. 8, 9).

7. A process for fabricating integrated circuits comprising the steps of:

a) providing a semiconductor substrate having device and interconnection metallurgy;

b) depositing a terminal pad level of metal, said terminal pad level including at least one pad (18) having a first shape and at least one pad (20) having a second shape;

c) coating said terminal pad level of metal with an insulating layer;

d) defining terminal vias through said insulation layer;

e) depositing a layer of ball limiting metallurgy on said insulating layer and through said terminal vias;

f) forming solder balls for input/output connections on said ball limiting metallurgy.

8. The process as claimed in claim 5 wherein said insulating layer is polyimide.

9. The process as claimed in claims 7 or 8 wherein said insulating layer is provided in a thickness or of a material as to be transparent for inspection from above.

10. The process of one of the preceding claims wherein the terminal pads of different shapes are formed with dimensions larger relative to the respective dimension of a later applied solder ball and, respectively, smaller than said solder ball as to be no longer visible from inspection from above (Figs. 8, 9).

FIG. 2.

FIG. 3.

FIG. 4.

# FIG. 5.

14

18

24

# FIG. 6.

20

24

# FIG. 7.

27

10

# FIG. 8.

24

18

# FIG. 9.

28

24

28

28

20